# EUROPEAN PATENT SPECIFICATION

(11) **EP 3 812 488 B1**
(45) Date of publication and mention of the grant of the patent: **22.10.2025**
(21) Application number: 19821920.6
(22) Date of filing: 29.05.2019
(51) Int. Cl.: C30B 23/02, C30B 29/36

(54) **DEVICE FOR GROWING SILICON CARBIDE SINGLE CRYSTAL AND METHOD FOR PRODUCING SILICON CARBIDE SINGLE CRYSTAL**
VORRICHTUNG ZUR ZÜCHTUNG EINES SILICUMCARBID-EINKRISTALLS SOWIE VERFAHREN ZUR HERSTELLUNG EINES SILICIUMCARBID-EINKRISTALLS
DISPOSITIF DE CROISSANCE DE MONOCRISTAL DE CARBURE DE SILICIUM, ET PROCÉDÉ DE PRODUCTION DE MONOCRISTAL DE CARBURE DE SILICIUM

(30) Priority: 20.06.2018 JP 2018117328
(43) Date of publication of application: 28.04.2021
(73) Proprietor: Shin-Etsu Handotai Co., Ltd., Tokyo 100-0004 (JP)
(72) Inventor: IKEDA Hitoshi, Annaka-shi, Gunma 379-0196 (JP); MATSUMOTO Yuichi, Annaka-shi, Gunma 379-0196 (JP); TAKAHASHI Toru, Annaka-shi, Gunma 379-0196 (JP)
(74) Representative: Wibbelmann, Jobst
(86) International application number: PCT/JP2019/021189
(87) International publication number: WO 2019/244580

(56) References cited:
- JP-A- 2004 269 297
- JP-A- 2004 269 297
- JP-A- 2011 207 691
- JP-A- 2017 065 934
- JP-A- 2017 065 934
- US-A1- 2008 026 546
- US-A1- 2010 139 552
- US-A1- 2012 103 251
- US-A1- 2017 321 345

## Description

### TECHNICAL FIELD

The present invention relates to: a silicon carbide single crystal growth apparatus; and a method for manufacturing a silicon carbide single crystal.

### BACKGROUND ART

Power devices that use a silicon carbide single crystal substrate have been attracting attention in recent years for having characteristics such as high breakdown voltage, low loss, and making a high-temperature operation possible.

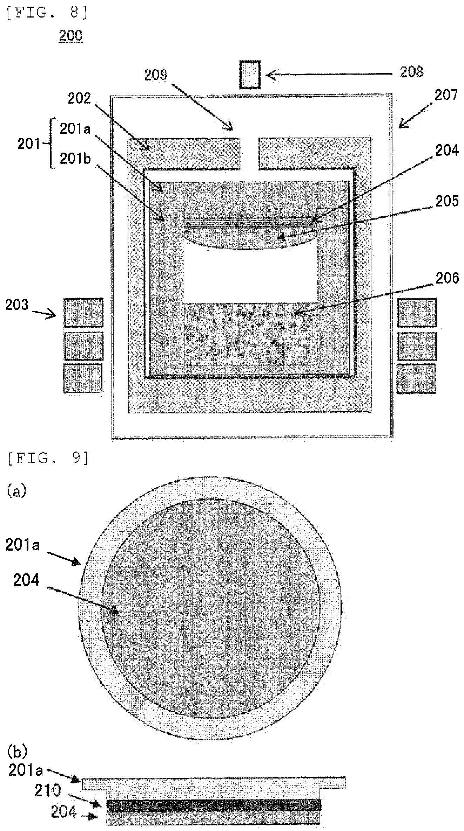

Specifically, a method for growing a silicon carbide single crystal by a sublimation method is a method of placing a silicon carbide raw material 206 (solid raw material silicon carbide) inside a growth container 201 of the silicon carbide single crystal growth apparatus 200 shown in FIG. 8, heating with a heater (high frequency heating coil) 203, and growing a silicon carbide single crystal 205 on a plate-shaped seed crystal substrate 204 disposed inside the growth container 201.

The growth container 201 is disposed inside a vacuum quartz pipe or inside a vacuum chamber, is once filled with a gas with low activity, and an atmosphere thereof has a pressure lower than an atmospheric pressure so that the sublimation rate of the silicon carbide is raised.

On the outside of the growth container 201, a heat-insulating container 202 is disposed. A part of the heat-insulating container 202 has at least one hole for temperature measurement 209 for measuring temperature with a temperature measuring equipment 208 such as a pyrometer. The growth container 201 is mainly formed from carbon material, and has permeability so that the pressures inside and outside the growth container 201 become equal. The silicon carbide raw material 206 is disposed at the bottom of the growth container 201. The silicon carbide raw material 206 is solid, and is sublimed under high temperature and reduced pressure. The sublimed silicon carbide raw material 206 grows as the silicon carbide single crystal 205 on the seed crystal substrate 204 facing the silicon carbide raw material 206.

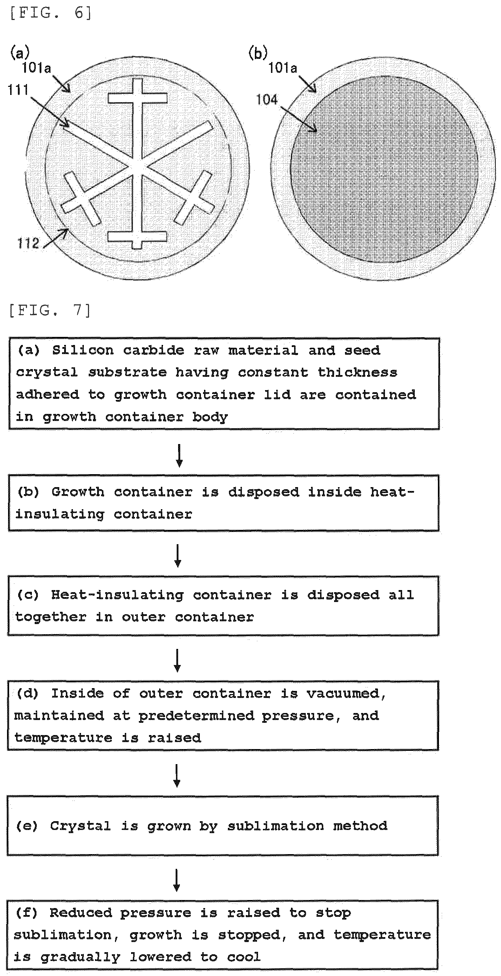

Here, a conventional method for manufacturing a silicon carbide single crystal using the above-described silicon carbide single crystal growth apparatus 200 will be described using FIG. 7 and FIG. 9. FIG. 7 is a diagram showing an example of a conventional method for manufacturing a silicon carbide single crystal. In addition, FIG. 9 is a diagram showing a state where a seed crystal substrate is adhered to an example of a conventional growth container lid. Firstly, as shown in FIG. 7 (a), a silicon carbide raw material 206 is disposed in a growth container body 201b. Next, as shown in FIG. 9 (a) and (b), a seed crystal substrate 204 formed from silicon carbide is stuck to a growth container lid 201a with, for example, a carbon adhesive 210, and is contained inside the growth container body 201b. Next, the growth container 201 is disposed inside the heat-insulating container 202 as shown in FIG. 7 (b). Next, this is disposed inside the outer container 207 all together the heat-insulating container 202 as shown in FIG. 7 (c). Next, the inside of the outer container 207 is vacuumed, maintained at a predetermined pressure (for example, 1 to 20 Torr), and the temperature is raised to 2000 to 2300°C as shown in FIG. 7 (d). Next, the silicon carbide single crystal 205 is grown on the seed crystal substrate 204 by the sublimation method as shown in FIG. 7 (e). Lastly, as shown in FIG. 7 (f), the pressure is raised to stop the sublimation, the growth is stopped, the temperature is gradually lowered, and cooling is performed (Patent Document 1).

Single crystals of silicon carbide include a cubic crystal and a hexagonal crystal, and furthermore, among hexagonal crystals, 4H, 6H, and the like are known as typical polytypes.

In many cases, the same type of single crystal grows; for example, 4H grows on a 4H type seed crystal (Patent Document 2).

A warp occurs in the seed crystal substrate 204 as in a bimetal with the rise in temperature due to the difference in coefficient of thermal expansion between the seed crystal substrate 204 and the growth container 201 mainly made from a carbon material. This leads to bending the basal plane of a silicon carbide single crystal, which is a hexagonal crystal, etc. It is considered that if a silicon carbide single crystal is grown on a bent basal plane, the crystal grows, maintaining the bend, and that this causes basal plane dislocation (BPD) and threading edge dislocation (TED), etc. while growing and cooling. This is also considered to be a cause for threading screw dislocation (TSD).

As described, many TSDs and TEDs that stretch continuously in the growth direction are present in a silicon carbide single crystal. BPDs are also present.

There is a problem that devices using a substrate manufactured from a silicon carbide single crystal with such dislocations present or even using a wafer with the quality of the crystal improved by further epitaxially growing an SiC on a substrate have a considerably lowered performance. For example, threading screw dislocation causes increase in the leakage current in a device. In addition, basal plane dislocation is said to become the source of killer defects in devices such as MOSFET.

To raise the yield in a substrate, it is important to reduce these dislocations. JP 2004-269297 A discloses a method for manufacturing the SiC single crystal comprising growing a bulk SiC single crystal on the growth surface of a SiC seed crystal in a growing vessel, wherein a stress relaxing material for relaxing thermal stress between the seed crystal and a pedestal for holding the seed crystal is arranged between the seed crystal and the pedestal.

### CITATION LIST

### PATENT LITERATURE

Patent Document 1: JP 2000-191399 A
Patent Document 2: JP 2005-239465 A
Patent Document 3: JP 2004-269297 A

### SUMMARY OF INVENTION

### TECHNICAL PROBLEM

The present invention has been made in view of the above-described problems, and an object thereof is to provide a silicon carbide single crystal growth apparatus and manufacturing method that can suppress the generation of threading screw dislocation, basal plane dislocation, and threading edge dislocation.

When an epitaxial growth is performed on a SiC substrate to make a device, threading screw dislocation and basal plane dislocation in particular are said to lead directly to the lowering of yields in a device.

### SOLUTION TO PROBLEM

To achieve the object, the present invention provides
a silicon carbide single crystal growth apparatus comprising:
a growth container comprising a growth container lid to which a seed crystal substrate is adhered and a growth container body for containing the seed crystal substrate and a silicon carbide raw material;
a heat-insulating container surrounding the growth container;
a temperature measuring equipment for measuring a temperature inside the growth container through a hole for temperature measurement provided in the heat-insulating container; and
a heater for heating the silicon carbide raw material, wherein
a silicon carbide single crystal is grown on the seed crystal substrate by heating and subliming the silicon carbide raw material by a sublimation method, wherein
the growth container lid has a pattern formed only within an adhesion region of the seed crystal substrate on the growth container lid, the pattern comprising at least one straight line that penetrates the growth container lid, characterized in that
   the pattern is formed radially from a center of the growth container lid to which the seed crystal substrate is adhered, or in that
   the pattern is formed concentrically.

In this manner, when a pattern penetrating the growth container lid is formed only within the adhesion region of the seed crystal substrate on the growth container lid, the bend in the basal plane of the seed crystal substrate can be resolved by elastic deformation of the seed crystal substrate or silicon carbide single crystal while growing and cooling even if a warp occurs. It is considered that the stress that the seed crystal substrate receives from the growth container lid can thus be reduced further in each step of raising the temperature, growing at a high temperature, and cooling. It can also be considered that this is neared by elastic deformation rather than plastic deformation. It is said that there is a difference in coefficient of expansion between the seed crystal substrate and the growth container, being the adhesion base of the seed crystal substrate, and that the difference in the coefficients of expansion generates the dislocations. However, the difference in the coefficients of expansion itself is not the cause, and whether the seed crystal substrate is heated or cooled, a state of there being little stress is approached by forming a penetrating pattern on the growth container lid, being a base for sticking the seed crystal substrate onto, and therefore, the generation of threading screw dislocation and basal plane dislocation can be suppressed.

Furthermore, in this event, the pattern is either formed radially from a center of the growth container lid to which the seed crystal substrate is adhered as defined in claim 1.

When the penetrating pattern has such a shape, a uniform elastic deformation over the entire substrate is possible in the seed crystal substrate and the silicon carbide single crystal, and therefore, the generation of threading screw dislocation and basal plane dislocation can be suppressed more certainly.

Alternatively, the pattern is preferably formed concentrically as defined in claim 1.

When the penetrating pattern is formed concentrically as well, a uniform elastic deformation over the entire substrate is possible in the seed crystal substrate and the silicon carbide single crystal, and therefore, the generation of threading screw dislocation and basal plane dislocation can be suppressed more certainly.

Furthermore, the pattern preferably has a width of 5 mm or less.

When the width of the penetrating pattern is 5 mm or less, sufficient adhesive strength can be ensured between the seed crystal substrate and the growth container lid, and therefore, risk of the silicon carbide single crystal coming off and falling is reduced.

In addition, the present invention provides a method for manufacturing a silicon carbide single crystal by growing the silicon carbide single crystal on a seed crystal substrate adhered to a growth container lid of a growth container by a sublimation method, wherein
the silicon carbide single crystal is grown using, as the growth container lid, the growth container lid having a pattern formed only within an adhesion region of the seed crystal substrate, the pattern comprising at least straight line that penetrates the growth container lid, characterized in that
the pattern is formed radially from a center of the growth container lid to which the seed crystal substrate is adhered, or in that
the pattern is formed concentrically.

By such a method for manufacturing a silicon carbide single crystal, the bend in the basal plane of the seed crystal substrate can be resolved by elastic deformation of the seed crystal substrate or silicon carbide single crystal while growing and cooling even if a warp occurs. Thus, the generation of threading screw dislocation and basal plane dislocation can be suppressed, and therefore, a silicon carbide single crystal with a low dislocation density can be manufactured.

Furthermore, in this event, the pattern is either formed radially from a center of the growth container lid to which the seed crystal substrate is adhered as defined in claim 1. In addition, it is further preferable to form the pattern along the six or twelve crystal habit lines of a hexagonal crystal of SiC.

When a growth container lid having a penetrating pattern with such a shape formed is used, a uniform elastic deformation over the entire substrate is possible in the seed crystal substrate and the silicon carbide single crystal, and therefore, the bend in the basal plane of the seed crystal substrate can be resolved. Thus, the generation of threading screw dislocation and basal plane dislocation can be suppressed more certainly.

In addition, in this event, the pattern is alternatively formed concentrically as defined in claim 1.

When a growth container lid having a concentrically formed penetrating pattern is used also, a uniform elastic deformation over the entire substrate is possible in the seed crystal substrate and the silicon carbide single crystal, and therefore, the bend in the basal plane of the seed crystal substrate can be resolved. Thus, the generation of threading screw dislocation and basal plane dislocation can be suppressed more certainly.

Furthermore, in this event, the pattern preferably has a width of 5 mm or less.

When a growth container lid formed with such a pattern width is used, sufficient adhesive strength can be ensured between the seed crystal substrate and the growth container lid, and therefore, risk of the silicon carbide single crystal coming off and falling is reduced.

### ADVANTAGEOUS EFFECTS OF INVENTION

The inventive silicon carbide single crystal growth apparatus has a pattern penetrating the growth container lid formed only within the adhesion region of the seed crystal substrate on the growth container lid so that the bend in the basal plane of the seed crystal substrate can be resolved by elastic deformation of the seed crystal substrate or silicon carbide single crystal while growing and cooling even if a warp occurs. Thus, the generation of threading screw dislocation and basal plane dislocation can be suppressed.

In addition, in the inventive method for manufacturing a silicon carbide single crystal, by using a growth container lid having a pattern penetrating the growth container lid formed only within the adhesion region of the seed crystal substrate, the bend in the basal plane of the seed crystal substrate can be resolved by elastic deformation of the seed crystal substrate or silicon carbide single crystal while growing and cooling even if a warp occurs. Thus, the generation of threading screw dislocation and basal plane dislocation can be suppressed, and therefore, a silicon carbide single crystal with a low dislocation density can be manufactured.

### BRIEF DESCRIPTION OF DRAWINGS

FIG. 1 is a schematic cross-sectional view showing an example of the inventive silicon carbide single crystal growth apparatus.
FIG. 2 is a flow diagram showing the inventive manufacturing method for manufacturing a silicon carbide single crystal.
FIG. 3 is a top view showing an example of the growth container lid of the inventive silicon carbide single crystal growth apparatus with a straight-line-shaped penetrating pattern formed.
FIG. 4 shows (a) a top view showing an example of the growth container lid of the inventive silicon carbide single crystal growth apparatus with a radial penetrating pattern formed, (b) a top view when a seed crystal substrate is adhered to an example of the growth container lid of the inventive silicon carbide single crystal growth apparatus with a radial penetrating pattern formed, (c) a cross-sectional view of FIG. 4 (a) at aa' and bb', and (d) a cross-sectional view of FIG. 4 (b) at aa' and bb'.
FIG. 5 shows (a) a top view showing an example of the growth container lid of the inventive silicon carbide single crystal growth apparatus with a pattern of a combination of radial and concentric penetrating patterns formed, and (b) a top view showing a different example of the growth container lid of the inventive silicon carbide single crystal growth apparatus with a pattern of a combination of radial and concentric penetrating patterns formed.
FIG. 6 shows (a) a top view showing an example of the growth container lid of the inventive silicon carbide single crystal growth apparatus with composite penetrating patterns formed in addition to radial penetrating patterns, and (b) a top view when a seed crystal substrate is adhered to an example of the growth container lid of the inventive silicon carbide single crystal growth apparatus with composite penetrating patterns formed in addition to radial penetrating patterns.
FIG. 7 is a diagram showing an example of a conventional method for manufacturing a silicon carbide single crystal.
FIG. 8 is a diagram showing an example of a conventional silicon carbide single crystal growth apparatus.
FIG. 9 shows (a) a top view when a seed crystal substrate is adhered to an example of a conventional growth container lid, and (b) a cross-sectional view when a seed crystal substrate is adhered to an example of a conventional growth container lid.
FIG. 10 is a figure showing observation photographs of dislocation pits in the Example ((a) and (b)) and observation photographs of dislocation pits in the Comparative Example ((c) and (d)) in a defect selective etching using molten KOH.

### DESCRIPTION OF EMBODIMENTS

Hereinafter, the present invention will be described in detail as an example of an embodiment with reference to the drawings, but the present invention is not limited thereto.

As described above, a warp that occurs in a seed crystal substrate leads to a bend in the basal plane of a silicon carbide single crystal and basal plane dislocation (BPD) and threading screw dislocation (TSD), etc. are generated occur in conventional technology. There has been a problem that the performance of devices that use a substrate manufactured from a silicon carbide single crystal having such dislocations present therein is considerably degraded.

The present inventors have earnestly studied and found out that when a pattern is formed only within an adhesion region of a seed crystal substrate on a growth container lid, the pattern including at least one straight line that penetrates the growth container lid, the generation of threading screw dislocation and basal plane dislocation can be suppressed, completing the present invention.

That is, the present invention is a silicon carbide single crystal growth apparatus including:
a growth container including a growth container lid to which a seed crystal substrate is adhered and a growth container body for containing the seed crystal substrate and a silicon carbide raw material;
a heat-insulating container surrounding the growth container;
a temperature measuring equipment for measuring a temperature inside the growth container through a hole for temperature measurement provided in the heat-insulating container; and
a heater for heating the silicon carbide raw material, where
a silicon carbide single crystal is grown on the seed crystal substrate by heating and subliming the silicon carbide raw material by a sublimation method, where
the growth container lid has a pattern formed only within an adhesion region of the seed crystal substrate on the growth container lid, the pattern including at least one straight line that penetrates the growth container lid, characterized in that
   the pattern is formed radially from a center of the growth container lid to which the seed crystal substrate is adhered, or in that
   the pattern is formed concentrically.

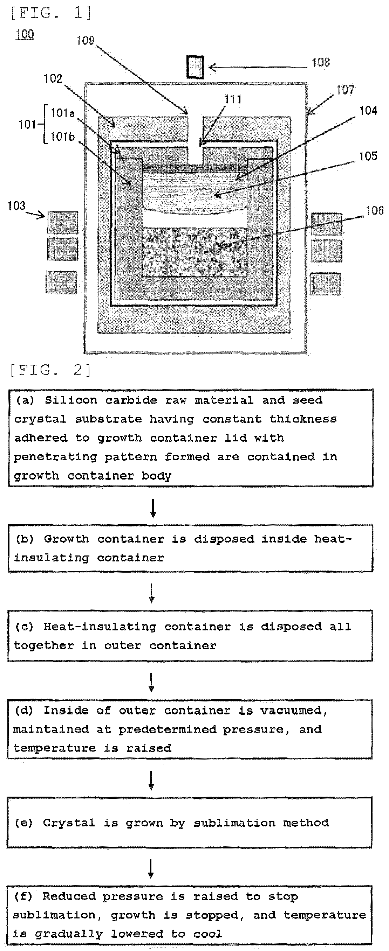

Hereinafter, the inventive silicon carbide single crystal growth apparatus will be described with reference to FIG. 1. FIG. 1 is a schematic cross-sectional view showing an example of the inventive silicon carbide single crystal growth apparatus for manufacturing a silicon carbide single crystal. The inventive silicon carbide single crystal growth apparatus 100 is an apparatus for growing a silicon carbide single crystal 105 on a seed crystal substrate 104 by heating and subliming the silicon carbide raw material 106 by a sublimation method.

The inventive silicon carbide single crystal growth apparatus 100 shown in FIG. 1 is equipped with: a growth container 101 including a growth container lid 101a to which a seed crystal substrate 104 is adhered and a growth container body 101b for containing the seed crystal substrate 104 and a silicon carbide raw material 106; a heat-insulating container 102 surrounding the growth container 101; a temperature measuring equipment 108 for measuring the temperature inside the growth container 101 through a hole for temperature measurement 109 provided at the top of the heat-insulating container 102; and a heater 103 for heating the silicon carbide raw material 106.

The growth container 101 is formed from a graphite with heat resistance, for example.

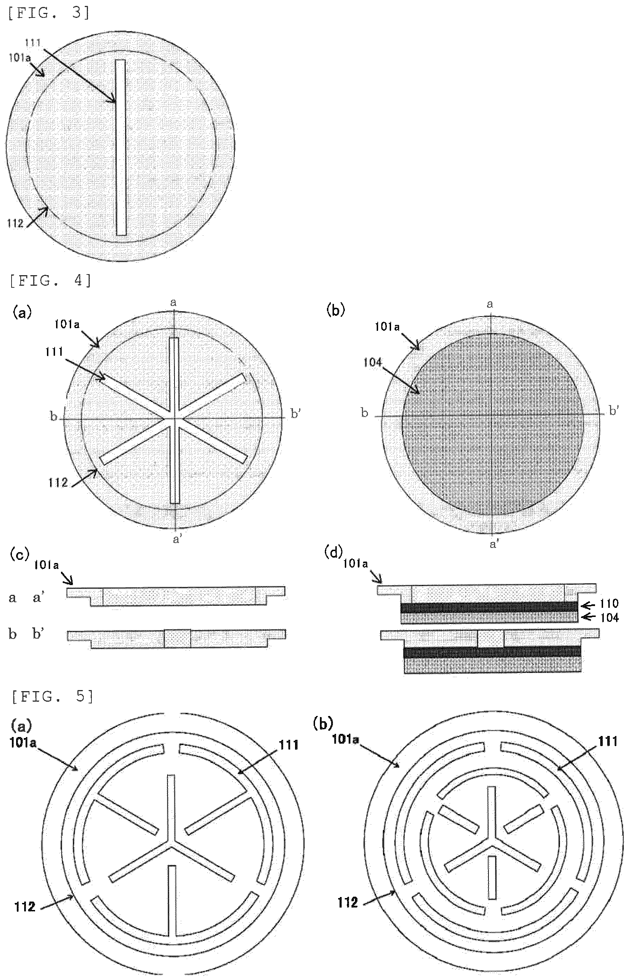

FIGS. 3 to 6 are diagrams showing examples of the growth container lid 101a of the inventive silicon carbide single crystal growth apparatus 100.

The inventive silicon carbide single crystal growth apparatus 100 has a pattern 111 penetrating the growth container lid 101a formed only within the adhesion region 112 of the seed crystal substrate 104 on the growth container lid 101a as shown in FIG. 4 (a) and (c). Examples of the shapes for the pattern 111 include: a straight line shape as shown in FIG. 3; a radial pattern as shown in FIG. 4 (a); a combination of a radial pattern and a concentric pattern as shown in FIG. 5 (a) and (b); and a pattern with a composite pattern formed in addition to a radial pattern as shown in FIG. 6 (a). Furthermore, the pattern 111 penetrating the growth container lid 101a may have a combined shape of a straight-line-shaped, curved-line-shaped, radial, concentric, and winding pattern, etc. In this manner, the pattern 111 can have various shapes, but in all cases, the pattern 111 is made so that the pattern 111 does not protrude from the seed crystal substrate 104 when the seed crystal substrate 104 is adhered (see FIG. 4 (b) and FIG. 6 (b)). If the pattern 111 protrudes from the seed crystal substrate, raw material gas escapes to the back of the growth container lid, inhibiting the growth of the silicon carbide single crystal 105.

In this manner, it is considered that when a pattern 111 penetrating the growth container lid 101a is formed within the adhesion region 112 of the seed crystal substrate 104 adhered to the growth container lid 101a, the bend in the basal plane of the seed crystal substrate 104 can be resolved by elastic deformation of the seed crystal substrate 104 or silicon carbide single crystal 105 while growing and cooling even if a warp occurs. Thus, the generation of dislocation can be suppressed.

Furthermore, when the penetrating pattern 111 has such shapes as those shown in FIGS. 3 to 6, a uniform elastic deformation over the entire substrate is possible in the seed crystal substrate 104 and the silicon carbide single crystal 105, and therefore, the generation of threading screw dislocation and basal plane dislocation can be suppressed more certainly.

Furthermore, the width of the pattern 111 is preferably 5 mm or less (more than 0 mm and 5 mm or less). When the pattern width is 5 mm or less, the adhesive strength of the seed crystal substrate becomes sufficient, and there is no risk of falling.

In addition, when growing a silicon carbide single crystal 105, the crystal growth is performed in an inert gas atmosphere under reduced pressure by setting the growth container 101 inside an outer container 107 made from SUS or quartz and supplying an inert gas such as Ar or N₂ while vacuum exhausting.

As the heater 103, a heater for performing RH (resistance heating) or RF (radiofrequency) heating can be used. In addition, by using a pyrometer as the temperature measuring equipment 108, temperature measurement can be performed with precision through the hole for temperature measurement 109 in the heat-insulating material from outside the growth container without contact.

A method for manufacturing a silicon carbide single crystal for manufacturing a silicon carbide single crystal 105 using the inventive silicon carbide single crystal growth apparatus 100 as described will be described using the flow diagram of FIG. 2.

Firstly, the silicon carbide raw material 106 is contained in the growth container body 101b as shown in FIG. 2 (a). Next, the seed crystal substrate 104 formed from silicon carbide is adhered to the growth container lid 101a having a pattern 111 penetrating the growth container lid 101a formed only within the adhesion region 112 of the seed crystal substrate 104 with, for example, a carbon adhesive 110 so that the pattern 111 portion is covered (see FIG. 4 (b), (d) and FIG. 6 (b)), and the seed crystal substrate 104 is contained in the growth container body 101b. Next, the growth container 101 including the growth container lid 101a and the growth container body 101b is disposed inside the heat-insulating container 102 as shown in FIG. 2 (b). Next, this is disposed inside the outer container 107 all together the heat-insulating container 102 as shown in FIG. 2 (c). Next, the inside of the outer container 107 is vacuumed, maintained at a predetermined pressure (for example, 1 to 20 Torr), and the temperature is raised to 2000 to 2300°C as shown in FIG. 2 (d). Next, the silicon carbide single crystal 105 is grown on the seed crystal substrate 104 by the sublimation method as shown in FIG. 2 (e). Lastly, as shown in FIG. 2 (f), the pressure is raised to stop the sublimation, the growth is stopped, the temperature is gradually lowered, and cooling is performed.

By such a method for manufacturing a silicon carbide single crystal, the bend in the basal plane of the seed crystal substrate 104 can be resolved by elastic deformation of the seed crystal substrate 104 or silicon carbide single crystal 105 while growing and cooling even if a warp occurs. Thus, the generation of threading screw dislocation and basal plane dislocation can be suppressed, and therefore, a silicon carbide single crystal with a low dislocation density can be manufactured.

Furthermore, in this event, the pattern 111 is preferably formed radially from the center of the growth container lid 101a to which the seed crystal substrate 104 is adhered as shown in FIG. 4 (a).

When a growth container lid 101a having a penetrating pattern 111 with such a shape formed is used, a uniform elastic deformation over the entire substrate is possible in the seed crystal substrate 104 and the silicon carbide single crystal 105, and therefore, the bend in the basal plane of the seed crystal substrate 104 can be resolved. Thus, the generation of threading screw dislocation and basal plane dislocation can be suppressed more certainly.

In addition, in this event, the pattern 111 is preferably formed as a concentrically penetrating pattern.

When a growth container lid having a concentrically penetrating pattern 111 is used also, a uniform elastic deformation over the entire substrate is possible in the seed crystal substrate 104 and the silicon carbide single crystal 105, and therefore, the bend in the basal plane of the seed crystal substrate 104 can be resolved. Thus, the generation of threading screw dislocation and basal plane dislocation can be suppressed more certainly.

Furthermore, in this event, the pattern 111 preferably has a width of 5 mm or less (more than 0 mm and 5 mm or less).

When a growth container lid 101a formed with such a pattern 111 width is used, sufficient adhesive strength can be ensured between the seed crystal substrate 104 and the growth container lid 101a, and therefore, risk of the silicon carbide single crystal 105 coming off and falling is eliminated.

### EXAMPLE

Hereinafter, the present invention will be described more specifically with reference to an Example and a Comparative Example, but the present invention is not limited thereto.

### (Example)

A silicon carbide seed crystal substrate with a 4-inch (101.6 mm) diameter was adhered to a growth container lid having a radially penetrating pattern formed as shown in FIG. 4, and a silicon carbide single crystal was grown according to the flow shown in FIG. 2. A silicon carbide single crystal substrate was sampled from the grown silicon carbide single crystal, and the densities of threading screw dislocation and basal plane dislocation were examined.

### (Comparative Example)

With a silicon carbide seed crystal substrate having a 4-inch (101.6 mm) diameter, a silicon carbide single crystal was grown according to the flow shown in FIG. 7, using a growth container lid with no penetrating pattern formed. A silicon carbide single crystal substrate was sampled from the grown silicon carbide single crystal, and the densities of threading screw dislocation and basal plane dislocation were examined.

The examination results of the densities of threading screw dislocation (TSD) in the silicon carbide single crystal substrates in the Example and the Comparative Example are shown in Table 1, the examination results of the densities of basal plane dislocation (BPD) in Table 2, and the examination results of the densities of threading edge dislocation (TED) in Table 3.

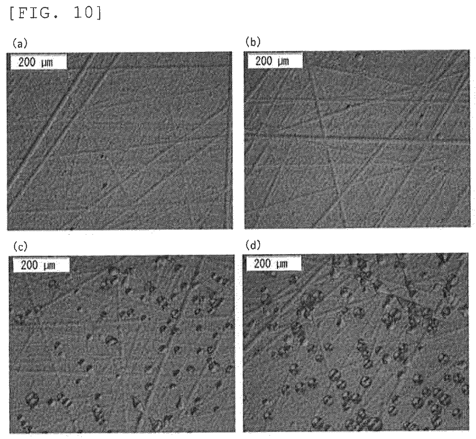

In addition, observation photographs of dislocation pits in the Example are shown in FIG. 10 (a) and (b), and observation photographs of dislocation pits in the Comparative Example are shown in FIG. 10 (c) and (d) in a defect selective etching using molten KOH.

**[Table 1]**

| Density of TSD | Conventional example | Example |
|---|---|---|
| Min | 3, 307 | 0 |
| Ave | 6, 531 | 28 |
| Max | 9, 590 | 331 |

| | | |
|---|---|---|
| Unit; number/cm2 | | |

**[Table 2]**

| Density of BPD | Conventional example | Example |
|---|---|---|
| Min | 1, 238 | 0 |
| Ave | 4, 341 | 14 |
| Max | 10, 304 | 165 |

| | | |
|---|---|---|
| Unit; number/cm2 | | |

**[Table 3]**

| Density of TED | Conventional example | Example |
|---|---|---|
| Min | 5, 952 | 331 |
| Ave | 8, 391 | 1, 097 |
| Max | 12, 897 | 2,811 |

| | | |
|---|---|---|
| Unit; number/cm2 | | |

As clearly seen from Table 1, Table 2, and Table 3, the Example had an extremely low result for every dislocation density compared with the Comparative Example, and all of the dislocation densities were improved considerably. In the Example, since a pattern penetrating the growth container lid was formed only within the adhesion region of the seed crystal substrate on the growth container lid, it was possible to resolve the bend in the basal plane of the seed crystal substrate by elastic deformation of the seed crystal substrate or silicon carbide single crystal while growing and cooling even if a warp had occurred. Thus, it was possible to suppress the generation of threading screw dislocation, basal plane dislocation, and threading edge dislocation.

In addition, as clearly seen from FIG. 10, the Example had a low result of etch pit density in the defect selective etching using molten KOH compared with the Comparative Example, and dislocation pits were reduced considerably.

## Claims

1. A silicon carbide single crystal growth apparatus comprising:
a growth container comprising a growth container lid to which a seed crystal substrate is adhered and a growth container body for containing the seed crystal substrate and a silicon carbide raw material;
a heat-insulating container surrounding the growth container;
a temperature measuring equipment for measuring a temperature inside the growth container through a hole for temperature measurement provided in the heat-insulating container; and
a heater for heating the silicon carbide raw material, wherein
a silicon carbide single crystal is grown on the seed crystal substrate by heating and subliming the silicon carbide raw material by a sublimation method, wherein
the growth container lid has a pattern formed only within an adhesion region of the seed crystal substrate on the growth container lid, the pattern comprising at least one straight line that penetrates the growth container lid, **characterized in that**
the pattern is formed radially from a center of the growth container lid to which the seed crystal substrate is adhered, or **in that**
the pattern is formed concentrically.

2. The silicon carbide single crystal growth apparatus according to claim 1, wherein the pattern has a width of 5 mm or less.

3. A method for manufacturing a silicon carbide single crystal by growing the silicon carbide single crystal on a seed crystal substrate adhered to a growth container lid of a growth container by a sublimation method, wherein
the silicon carbide single crystal is grown using, as the growth container lid, the growth container lid having a pattern formed only within an adhesion region of the seed crystal substrate, the pattern comprising at least one straight line that penetrates the growth container lid, **characterized in that**
the pattern is formed radially from a center of the growth container lid to which the seed crystal substrate is adhered, or **in that**
the pattern is formed concentrically.

4. The method for manufacturing a silicon carbide single crystal according to claim 3, wherein the pattern has a width of 5 mm or less.

## Patentansprüche

1. Vorrichtung zum Züchten von Siliziumkarbid-Einkristallen, die umfasst:
einem Wachstumsbehälter, der einen Wachstumsbehälterdeckel, an dem ein Keimkristallsubstrat haftet, und einen Wachstumsbehälterkörper zum Aufnehmen des Keimkristallsubstrats und eines Siliziumkarbid-Rohstoffs umfasst;
einen den Wachstumsbehälter umgebenden wärmeisolierenden Behälter;
eine Temperaturmessvorrichtung zum Messen einer Temperatur innerhalb des Wachstumsbehälters durch eine in dem wärmeisolierenden Behälter vorgesehene Temperaturmessöffnung; und
eine Heizvorrichtung zum Erhitzen des Siliziumkarbid-Rohstoffs, wobei
ein Siliziumkarbid-Einkristall auf dem Keimkristallsubstrat durch Erhitzen und Sublimieren des Siliziumkarbid-Rohstoffs durch ein Sublimationsverfahren gezüchtet wird, wobei
der Wachstumsbehälterdeckel ein Muster aufweist, das nur innerhalb eines Haftbereichs des Keimkristallsubstrats auf dem Wachstumsbehälterdeckel ausgebildet ist, wobei das Muster mindestens eine gerade Linie umfasst, die den Wachstumsbehälterdeckel durchdringt, **dadurch gekennzeichnet, dass**
das Muster radial von einer Mitte des Wachstumsbehälterdeckels, an dem das Keimkristallsubstrat haftet, ausgebildet ist, oder dass
das Muster konzentrisch ausgebildet ist.

2. Vorrichtung zum Züchten von Siliziumkarbid-Einkristallen nach Anspruch 1, wobei das Muster eine Breite von 5 mm oder weniger aufweist.

3. Verfahren zur Herstellung eines Siliziumkarbid-Einkristalls durch Züchten des Siliziumkarbid-Einkristalls auf einem Keimkristallsubstrat, das an einem Wachstumsbehälterdeckel eines Wachstumsbehälters durch ein Sublimationsverfahren haftet, wobei
der Siliziumkarbid-Einkristall unter Verwendung des Wachstumsbehälterdeckels, der ein Muster aufweist, das nur innerhalb eines Haftbereichs des Keimkristallsubstrats ausgebildet ist, als den Wachstumsbehälterdeckel gezüchtet wird, wobei das Muster mindestens eine gerade Linie umfasst, die den Wachstumsbehälterdeckel durchdringt, **dadurch gekennzeichnet, dass**
das Muster radial von einer Mitte des Wachstumsbehälterdeckels, an dem das Keimkristallsubstrat haftet, ausgebildet ist, oder dass
das Muster konzentrisch ausgebildet ist.

4. Verfahren zur Herstellung eines Siliziumkarbid-Einkristalls nach Anspruch 3, wobei das Muster eine Breite von 5 mm oder weniger aufweist.

## Revendications

1. Appareil de croissance de monocristal de carbure de silicium comprenant:
un récipient de croissance comprenant un couvercle de récipient de croissance auquel adhère un germe cristallin et un corps de récipient de croissance contenant le substrat de germe cristallin et un produit de départ de carbure de silicium;
un conteneur d'isolation thermique entourant le récipient de croissance;
un équipement de mesure de température pour mesurer la température à l'intérieur du récipient de croissance à travers un trou pour mesurer la température générée dans le récipient d'isolation thermique; et
un dispositif de chauffage pour chauffer le produit de départ de carbure de silicium, dans lequel
un monocristal de carbure de silicium croît sur le de germe cristallin par chauffage et sublimation du produit de départ de carbure de silicium selon une méthode de sublimation,
le couvercle du récipient de croissance comportant un motif formé uniquement dans une zone d'adhérence du substrat germe cristallin sur le couvercle du conteneur de croissance, le motif comprenant au moins une ligne droite qui pénètre dans le conteneur du récipient de croissance, **caractérisé en ce que**
le motif est formé radialement à partir d'un centre du couvercle du récipient de croissance auquel le germe cristallin est collé, ou **en ce que**
le motif est formé de manière concentrique.

2. Appareil de croissance de monocristal de carbure de silicium selon la revendication 1, dans lequel la largeur du motif est inférieure ou égale à 5 mm.

3. Procédé de fabrication d'un monocristal de carbure de silicium par croissance d'un monocristal de carbure de silicium, par une méthode de sublimation, sur un germe cristallin collé à un couvercle de récipient de croissance d'un récipient de croissance, dans lequel
le monocristal de carbure de silicium croît à l'aide, comme couvercle de récipient de croissance, du couvercle du récipient de croissance doté d'un motif formé uniquement à l'intérieur d'une zone d'adhérence du germe cristallin, le motif présentant au moins une ligne droite qui pénètre dans le couvercle de récipient de croissance, **caractérisé en ce que**
le motif est formé radialement à partir d'un centre du couvercle de conteneur de croissance auquel le germe cristallin est collé, ou **en ce que**
le motif est formé concentriquement.

4. Procédé de fabrication d'un monocristal de carbure de silicium selon la revendication 3, dans lequel la largeur du motif est inférieur ou égale à 5mm.
